Europäisches Patentamt

European Patent Office

Office européen des brevets

(11) Publication number: **0 150 260**
A2

# EUROPEAN PATENT APPLICATION

(21) Application number: 84110138.9

(22) Date of filing: 24.08.84

(51) Int. Cl.⁴: **G 06 F 11/26,** G 01 R 31/28

(30) Priority: 30.01.84 US 575368

(71) Applicant: **VALID LOGIC SYSTEMS, INC., 2820 Orchard Parkway, San Jose California 95314 (US)**

(43) Date of publication of application: 07.08.85 Bulletin 85/32

(72) Inventor: **Widdoes, Curtis L., Jr., 19700 Duff, Sunnyvale California 94086 (US)**

(74) Representative: **KUHNEN & WACKER Patentanwaltsbüro, Schneggstrasse 3-5 Postfach 1729, D-8050 Freising (DE)**

(84) Designated Contracting States: **DE FR GB IT**

(54) Method for sensing and simulating digital logic states.

(57) In an apparatus for simulating operation of digital circuit systems, a method for sensing signal values at device terminals comprises comparing the drive level of an output terminal with the drive level of a high impedance source.

## METHOD FOR SENSING AND SIMULATING
## DIGITAL LOGIC STATES

### BACKGROUND OF THE INVENTION

This invention relates to modeling of operation of complex large scale integration (LSI) or very large scale integration (VLSI) devices for use in development and testing of complex circuitry and systems. More specifically, the invention relates to logic simulation and testing of complex digital circuitry and systems including those capable of executing instructions under program control in which performance characteristics of LSI or VLSI devices must also be accurately simulated. In particular, this invention is related to solutions to problems related to development of logic-simulation models built around hardware library elements, as disclosed in the parent application. It is believed that to date no one other than the present inventor and his co-workers is active in this field.

A logic-simulation model of a device is a diagnostic tool which accurately mimics logical and timing behavior of a device in normal operation. The purpose of such a model is to verify both logic and timing of an operational digital system containing the device. In a logic-simulation model, internal operation and internal structure need not be similar to that of the actual device being simulated. The only prerequisite is that the operation as externally observed be similar to the actual device being modeled.

Conventional logic-simulation models have been implemented with·software. The present invention in contrast is a development around logic simulation models based on library elements which are the actual hardware devices and which interact with other library elements through a combination of hardware and software.

Software logic-simulation models have been of two types, namely, structural models and behavioral models. A structural model mimics actual internal logical structure of a device from which observable functional behavior follows. A behavioral model merely mimics external logical and timing behavior.

Software models of complex devices have numerous disadvantages. First, they are relatively costly and time consuming to develop. Also, to design an accurate model, specifications of the device must be gathered and thoroughly understood. This has been a serious limitation because manufacturers of devices are generally reluctant to disclose such details. Moreover, the specifications required for modeling a device are typically much more detailed than those relevant to a typical user of the device.

Furthermore, software simulation models are characteristically slow because of the amount of computation required to simulate device functions. Typically, the amount of computation required to simulate external components is negligible compared with the amount of computation required to simulate the complex device itself. In fact, software simulation models are frequently too slow to be of practical utility.

It has been discovered in the course of developing a hardware-based complex circuit simulation system that limitations in hardware sensing capabilities have prevented convenient sensing of the logic output values. In particular it has been found to be difficult to sense the high impedance condition on certain terminals of a reference element.

## SUMMARY OF THE INVENTION

According to the invention, in an apparatus for simulating operation of digital circuit systems, a method for sensing signal values at device output terminals comprises comparing the drive level of an output terminal with the drive level of a high impedance source. Accordingly, simple current sensing circuitry, such as a resistor coupled to each signal terminal and driven in common with other sensing resistors, is employed to distinguish between signal levels representing values.

The invention will be better understood by reference to the following detailed description taken in connection with the accompanying drawings.

## BRIEF DESCRIPTION OF THE DRAWINGS

Figure 1 is a block diagram of a simulation system with simulation modeling apparatus.

Figure 2 is a representation of a memory map of a computer controlled simulation system.

Figure 3 is a block diagram of a simulation jig operative according to the invention.

Figure 4 is a schematic diagram of a current sensing circuit.

## DESCRIPTION OF SPECIFIC EMBODIMENTS

In order to better understand the invention, it is helpful to consider operation of a simulation system capable of employing the inventive method. The inventive method will then be illustrated by an example.

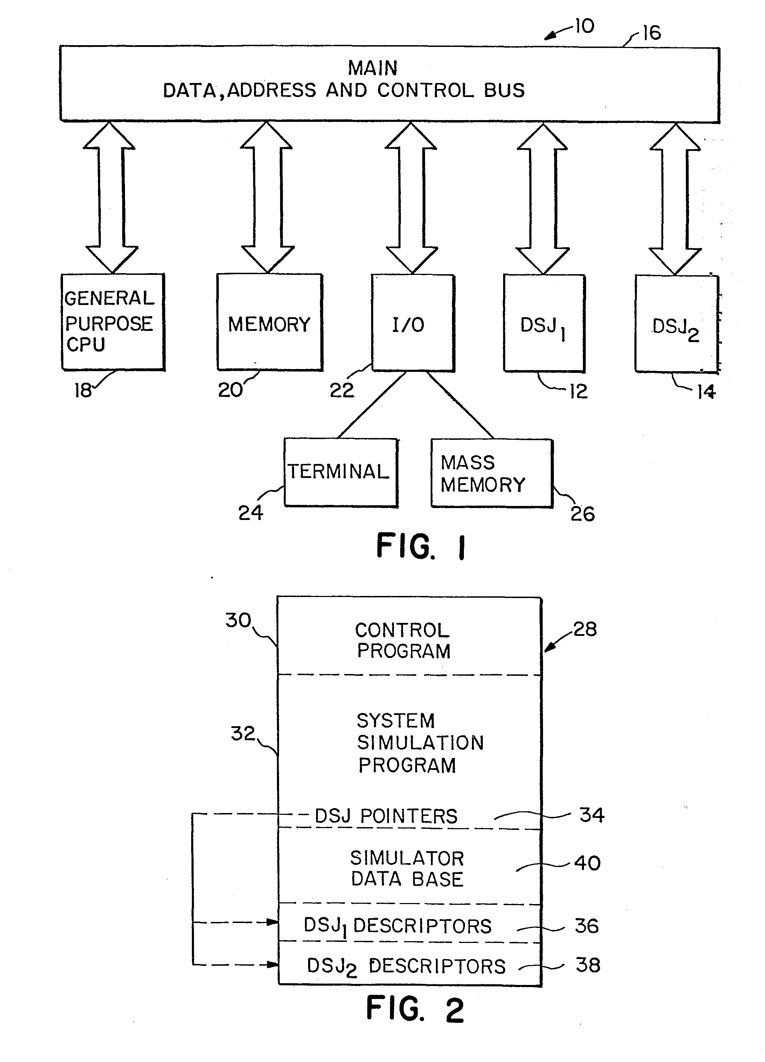

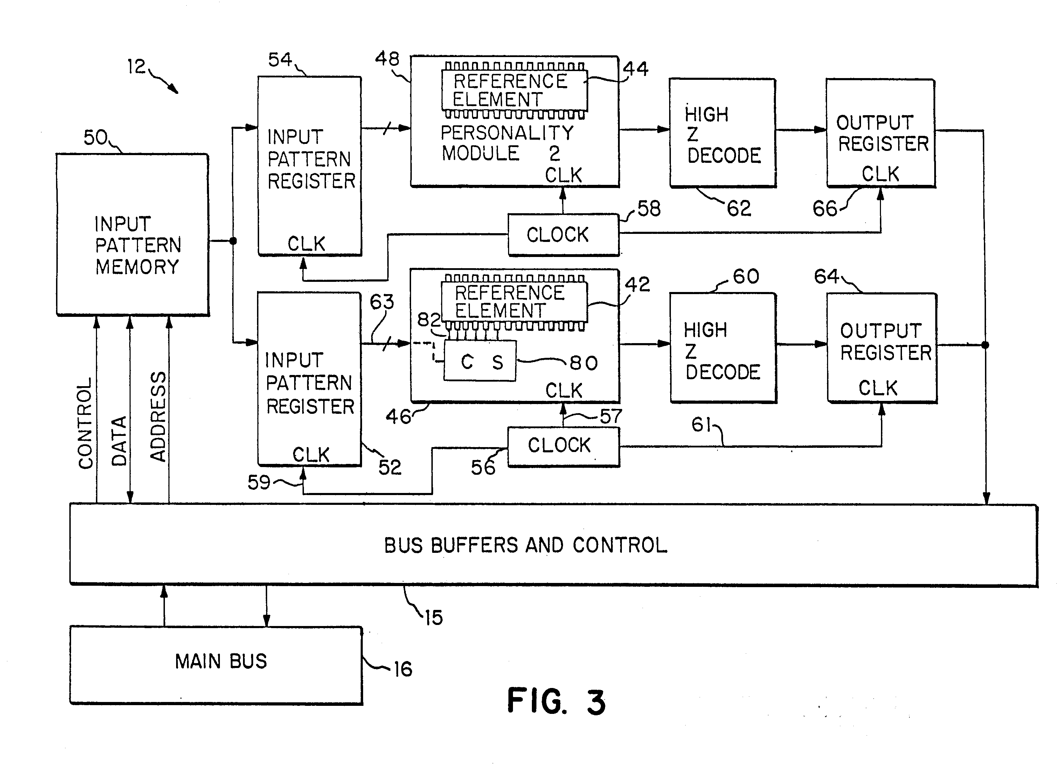

Referring to Figure 1, there is shown a simulation system 10 as might be configured in a general purpose digital computer having a general purpose central processing unit (CPU) 18 coupled to a main bus 16. The simulation system further may include a memory means 20 and input/output means (I/O) 22 coupled to the main bus 16. A control terminal 24 and mass memory 26 are coupled through the I/O 22 to the main bus 16. Whereas a. completely software-based simulation requires no other hardware, in the present invention a first simulation jig (DSJ$_1$) 12 and/or a second simulation jig (DSJ$_2$) 14 may be coupled to the main bus 16. The functions of the simulation jigs 12 and 14 are explained in connection with Figure 3.

Referring to Figure 2, there is shown schematically how the software of the simulation system 10 may be organized in a memory map 28 of the memory 20. Memory space is set aside for a computer system control program 30 in memory 20. A system simulation program 32 is stored as object code in a memory 20. Also stored in memory 20 are pointers 34 to descriptors 36 and 38 of the simulation jigs 12 and 14. A simulator database 40 containing working data values for the system simulation program is stored on-line in memory 20. Memory 20 is also used to store data as required by the simulation program from the mass memory 26.

Consider operation of a simulation jig 12 operative to present input patterns through an input pattern register 52 to a device herein known as a reference element 42, as shown in Figure 3. (Most control signal lines have not been shown to avoid unnecessary complexity. Implementation of control functions is within the skill of the original designer from the present description.) One or more clock signals having preselectable shape, clock rate and relative phase relationship may be presented by a clock 56 via clock lines 57, 59 and 61 to a personality module 46, the input pattern register 52 and the output register 64. The output register 64 receives its signal through a high impedance decoder 60 which is operative to sense for open circuits. If output drive is inadequate then the decoder 60 cannot distinguish between high states and high impedance states. The personality module 46 is a customized interface device which provides signal level matching and a suitable socket for a general purpose simulation jig 12. The simulation jig 12 is operative to present a set of input signals to the reference element 42 synchronous with the clock 56, which input signals represent values stored in an input pattern memory 50 containing the full set of defined input signal patterns in logical sequence. The input pattern memory 50 may be a serial or random access memory device with control lines and ports appropriate to the type of memory element selected.

At a fixed time relative to each clock period or edge, the input pattern register 52 of the simulation jig 12 is operative to produce output signals as if it were operating in a real-time environment in response to the defined input signal pattern. However, the output signals are ignored by the data recovery element, namely the output register 64, until all available input patterns in a sequence have been presented to the reference element 42. After the last input pattern has been presented to the reference element 42, clocking stops. An interval follows which is greater than the maximum specified delay of any output of the reference element 42. Thereupon the output values are sampled and stored in the output register 64. Thereafter, the simulator system 10 (Figure 1) to which the simulation jig 12 is coupled via bus buffers and control 15 and main bus 16 examines the state of each output of the reference element 42. The states are evidenced by the values in the output register 64. The simulator system 10 then schedules the simulated outputs in the simulator data base 40 to change at specific delay times after the corresponding input transition. The specified delay time for each output is a function of the identity of the output which changes and the identity of the input which causes the change. It can be set to any time value between the minimum and the maximum delay as specified by the manufacturer and is a parameter which is specified in the definition of the device corresponding to the reference element 42. (Experience suggests that the maximum delay time be chosen in order to reveal the most timing errors in a design under development.)

According to the invention, high impedance or high-Z decode means 60 is provided with current sensing means which is operative to compare the drive level at the device terminals with the drive level of a high impedance source.

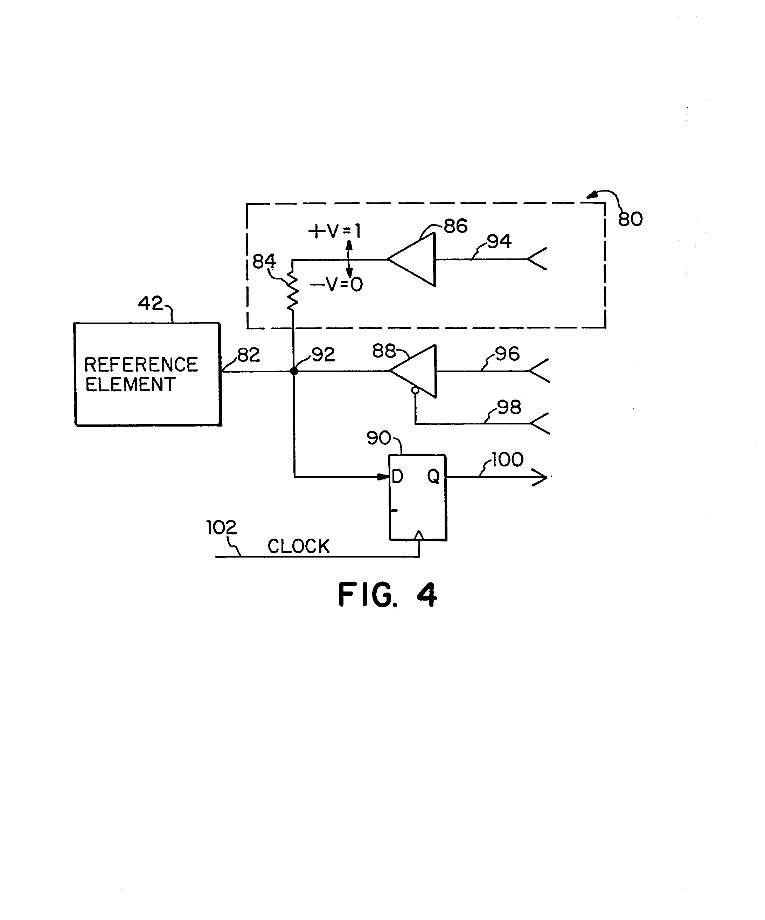

Referring to Figure 4, there is shown one embodiment of a current sensing means 80 coupled to a node 92 of an input/output terminal 82 of a reference element 42 as might be found in the system of Figure 3. Coupled to the node 92 are a three state driver 88 and a data latch 90. The driver 88 is controlled by a two state data line 96 and is enabled by an enable line 98. The driver 88 has adequate current drive to force the state at signal terminal 82 whenever the enable line 98 is active. The data latch 90 is a high input impedance register operative to read out the state of the signal terminal 82 to the output line 100 at the occurrence of a clock transition induced by activation of a clock line 102. The driver 88 and data latch 90 are examples of circuitry coupled to every input/output signal line.

The current sensing means 80 comprises a resistor 84 coupled to the node 92 of the signal terminal 82 and driven by a test driver element 86 which is controlled by a data test line 94.

A common test driver element 86 may provide drive to a plurality of resistors 84, each resistor 84 being coupled to a node of a different terminal 82. The value of the resistor is sufficiently high for developing a measurable voltage drop thereacross in response to a relatively small drive provided at the signal terminal 82. The data latch 90 samples the voltage level at node 92 and supplies the result to the output line 100. The values on the data test line 94, the data line 96, the enable line 98 and the output line 100 will indicate the value at the signal terminal 82.

A typical sensing procedure operates as follows: The driver 88 forces the signal terminal 82 to either a high value or a low value so as to precharge the node 92. The enable line 98 deactivates the driver 88. The data test line 94 switches the output of the test driver element 86 to either a high voltage (+5V) or a low voltage (-5V) thereby to preset the voltage reference level of one terminal of the resistor 84. The data latch 90 then samples the voltage level at node 92. The voltage at the signal terminal 82 will be indicative of the drive level and state of the signal terminal 82. Since the resistor 84 is of relatively high impedance, any low impedance drive will force the state at node 92. If signal terminal 82 is "high impedance" then node 92 will attain the same state as data text line 94.

A specific example will illustrate. Consider a driver 88 which precharges the node 92 to a value and is then disabled. Consider further a test driver element 86 providing as a high value +5 volt and as a low value -5 volt coupled to a high impedance resistor 84, for example having a resistance of 18,000 ohms. A low value is presented through the resistor 84 to the node 92. The node 92 is sampled. Then a high value is presented and again sampled. If the data latch 90 reads a low value (0) and a high value (1), then it can be concluded that the signal terminal 82 is at high impedance, since there is inadequate current at the node 92 to overcome the high impedance presented by the test driver element 86. Suppose however that the test driver element 86 presents a low value and a high value and that the data latch 90 reads, respectively, a high value and a high value when the driver 88 is disabled. The output 100 may then be designated as a high value. This is because the current inducing the voltage drop across resistor 84 is sufficient to maintain the voltage at node 92 at a level above the threshold for high values as sensed by data latch 90.

Next, suppose that the test driver element 86 presents a low value and a high value and that data latch 90 reads, respectively, low value and a low value while the driver 88 is disabled. The output 100 may then be designated as a low value.

Finally, suppose that the test driver element 86 presents a low value and a high value which are read, respectively, as a high value and a low value. This is a condition which should not occur in a correctly constructed test system. It is thus an indication that either the test system or the reference element 42 is defective. At best the value can be designated as unknown, and an effort should be made to correct the problem before further simulation is carried out.

The choice the value of resistance of resistor 84 and test drive voltages are important considerations in a practical system. A proper choice depends on the nature of the circuitry to be tested. The resistance must be sufficiently large so that normal output drive will overcome any current through the resistor, and the test drive voltages must be such that normal leakage currents can be viewed as high impedance conditions.

The invention has now been explained with reference to specific embodiments. Other embodiments will be apparent to those of ordinary skill in the art. Therefore, it is not intended that this invention be limited, except as indicated by the appended claims.

0150260

CLAIMS

WHAT IS CLAIMED IS:

1.    In an apparatus for simulating operation of a digital circuit system, a method for detecting the presence of a high impedance condition on a terminal of a complex digital device in said digital circuit system wherein a physical specimen of said complex circuit device is employed as an operational reference element, said method comprising the steps of:

driving said terminal with high impedance current source having a first voltage level representative of a first binary value;

sensing voltage level at said terminal to determine a third binary value;

driving said terminal with high impedance current source having second voltage level representative of a second binary value;

sensing voltage level at said terminal to determine a fourth binary value; and

designating said terminal as being in a high impedance condition where said fourth binary value differs from said third binary value.

2. The method according to claim 1 further including the step of designating said terminal as being in a condition corresponding to said first binary value where said first binary value is the same as said third binary value.

3. The method according to claim 1 further including the step of designating said terminal as being in a condition corresponding to said second binary value where said second binary value is the same as said fourth binary value.

4. In an apparatus for simulating operation of a digital circuit system, a method for detecting the presence of a high impedance condition on a terminal of a complex digital device in said digital circuit system wherein a physical specimen of said complex circuit device is employed as an operational reference element, said method comprising the steps of:

driving said terminal with a high impedance current source toward a first voltage level representative of a first binary value;

sensing level of voltage at said terminal to determine binary value;

driving said terminal with said current source toward a second voltage level representation of a second binary value;

sensing level of voltage at said terminal to determine binary value; and

designating binary value at said terminal as corresponding to said first binary value or to said second binary value in accordance with said sensing.

**MAIN DATA, ADDRESS AND CONTROL BUS** 16

10

- GENERAL PURPOSE CPU 18
- MEMORY 20
- I/O 22
- DSJ$_1$ 12
- DSJ$_2$ 14

TERMINAL 24

MASS MEMORY 26

**FIG. 1**

- CONTROL PROGRAM 30, 28
- SYSTEM SIMULATION PROGRAM 32
- DSJ POINTERS 34
- SIMULATOR DATA BASE 40
- DSJ$_1$ DESCRIPTORS 36
- DSJ$_2$ DESCRIPTORS 38

**FIG. 2**

FIG. 3

FIG. 4